(19) Europäisches Patentamt
European Patent Office
Office européen des brevets

(11) **EP 2 954 616 B1**

(12) **EUROPÄISCHE PATENTSCHRIFT**

(45) Veröffentlichungstag und Bekanntmachung des Hinweises auf die Patenterteilung:
**15.03.2017 Patentblatt 2017/11**

(21) Anmeldenummer: **14720913.4**

(22) Anmeldetag: **08.04.2014**

(51) Int Cl.:
*H03K 3/53* (2006.01)    *H03K 3/537* (2006.01)

(86) Internationale Anmeldenummer:
**PCT/EP2014/057009**

(87) Internationale Veröffentlichungsnummer:
**WO 2014/170164 (23.10.2014 Gazette 2014/43)**

(54) **VORRICHTUNG UND VERFAHREN ZUR ERZEUGUNG VON HOCHSPANNUNGSIMPULSEN**

DEVICE AND METHOD FOR THE GENERARTION OF HIGH VOLTAGE PULSES

DISPOSITIF ET PROCÉDÉ POUR GÉNÉRER DES IMPULSIONS À HAUTE TENSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.04.2013 DE 102013207020**

(43) Veröffentlichungstag der Anmeldung:
**16.12.2015 Patentblatt 2015/51**

(73) Patentinhaber: **Siemens Aktiengesellschaft 80333 München (DE)**

(72) Erfinder:
- **HARTMANN, Werner 91085 Weisendorf (DE)**
- **HERGT, Martin 90411 Nürnberg (DE)**

(56) Entgegenhaltungen:
**US-A- 6 066 901**

- **KOHNO S ET AL: "HIGH-CURRENT PULSED POWER GENERATOR ASO-X USING INDUCTIVE VOLTAGE ADDER AND INDUCTIVE ENERGY STORAGE SYSTEM", JAPANESE JOURNAL OF APPLIED PHYSICS, JAPAN SOCIETY OF APPLIED PHYSICS, JP, Bd. 39, Nr. 5A, PART 01, 1. Mai 2000 (2000-05-01), Seiten 2829-2833, XP001014997, ISSN: 0021-4922, DOI: 10.1143/JJAP.39.2829**
- **THOMAS K J ET AL: "Linx and future iva machines", 19990414; 19990414 - 19990415, 14. April 1999 (1999-04-14), Seiten 2/1-2/4, XP006501418,**

**Beschreibung**

Die Erfindung betrifft eine Vorrichtung zur Erzeugung von Hochspannungsimpulsen gemäß dem Oberbegriff des Hauptanspruchs und ein entsprechendes Verfahren gemäß dem Nebenanspruch.

In der Elektrotechnik werden auf dem Gebiet der Leistungsimpulstechnik (Pulsed Power) Hochspannungs- und Hochleistungspulse von einigen kW bis zu mehreren Hundert TW Amplitude für wissenschaftliche und industrielle Zwecke genutzt, wobei Impulsdauern im ps- bis ms-Bereich liegen.

Für die sogenannte Elektroporation, die hier als ein Beispiel für eine industrielle Anwendung genannt ist, ist ein Pulsgenerator erforderlich, der beispielsweise Spannungen von 250 kV, Ströme von einigen 10 kA mit einer Pulsdauer von 1 $\mu$s bis 2 $\mu$s erzeugen kann.

Eine mögliche Topologie zur Realisierung eines derartigen Pulsgenerators ist ein sogenannter "inductive voltage adder" der mit IVA abgekürzt wird. Ein derartiger Generator ermöglicht einen kompakten Aufbau, da dieser sich während einer Pulsgenerierung als eine Serienschaltung von n diskreten Spannungsquellen zusammensetzt. Physikalisch werden in einer Transformator (transformer) genannten Leitergeometrie die elektromagnetischen Felder im IVA kombiniert.

"Pulsed Power Systems Principles and Applications", Hansjochim Bluhm, Springer Verlag Berlin Heidelberg, 2006 offenbart insbesondere in Kapitel 7, S. 192-201, Aufbau und Wirkungsweisen von IVAs.

Auf diese Weise bestimmt der Transformer beziehungsweise Transformator im Wesentlichen das Design eines IVA (induktiver Spannungsaddierer). Durch ein geeignetes Design der einzelnen Transformator-Stufen kann eine modulare Bauweise zur Optimierung der Größe des IVA gewonnen werden. Insbesondere ist es erforderlich, dass die einzelnen aufeinanderfolgenden Stufen elektrisch optimal aneinander angepasst werden, sodass keine Reflexionen der elektrischen Signale zwischen den Stufen erfolgen, welche die Funktionsweise des IVA infrage stellen würden. Dies gilt insbesondere für die erste und die zweite Stufe, da in der herkömmlicherweise meist verwendeten koaxialen Anordnung die erste Stufe geometrisch nicht identisch mit der zweiten Stufe ausgeführt werden kann, da diese selber keine Eingangsseite aufweist.

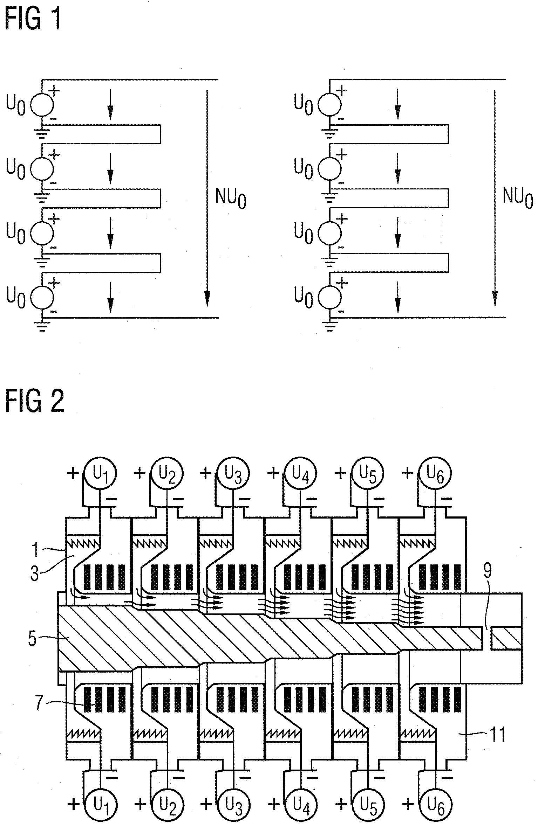

Mit einem IVA können die Welleneigenschaften, bedingt durch die Reflexionsfaktoren, während des Einschaltvorgangs und im stationären Zustand zur Erhöhung der Stromamplitude verwendet werden. Figur 1 zeigt das herkömmliche Prinzip eines IVA. Figur 1 zeigt das Grundprinzip des IVA am Beispiel von vier Stufen. Ähnlich wie bei einer seriellen Anordnung von Spannungsquellen, die in Figur 1 auf der linken Seite dargestellt sind, lassen sich Impulsleitungen, wie sie auf der rechten Seite der Figur 1 dargestellt sind, als Spannungsvervielfacherschaltungen realisieren, indem man den positiven Leiter der einen Leitung mit dem negativen Leiter der anderen verbindet. Damit bei dieser alternierenden Verbindung der Leiter kein Kurzschluss entsteht, muss die Verbindung für die Dauer des Impulses isoliert sein. Dies lässt sich mit Hilfe von ausreichend langen Übertragungsleitungen, in Form eines Kabeltransformators, oder über die Kopplung mit hinreichend hohen Koppelinduktivitäten, entsprechend der Ausführungsform eines IVA, erreichen. Ein kompakterer Aufbau ist möglich, wenn an Stelle der Laufzeit eine induktive Isolation bei der Addition der Impulsleitungen einzelner Stufen verwendet wird. Das Prinzip der Spannungsaddition mittels magnetischer Isolation, gemäß dem IVA, ist in Figur 2 dargestellt.

Figur 2 zeigt ein herkömmliches Ausführungsbeispiel eines IVA mit magnetischer Isolation. Figur 2 zeigt sechs Stufen, die koaxial angeordnet sind. Bezugszeichen 1 bezeichnet eine Vakuumschnittstelle, Bezugszeichen 3 bezeichnet ein Vakuum, Bezugszeichen 5 bezeichnet eine ringförmige Lücke, Bezugszeichen 7 bezeichnet einen magnetischen Kern, Bezugszeichen 9 bezeichnet eine Diode und Bezugszeichen 11 bezeichnet Öl. Die zylindrischen Kavitäten bilden einen inneren Leiter des IVA und werden radial von herkömmlichen, koaxial angeordneten Spannungsquellen Ux gespeist. Im Falle der beschriebenen Anwendungen liefert jede der einzelnen Kavitäten einen Impuls von beispielsweise 0,1 bis 50 $\mu$s Dauer mit einer Spannungsamplitude $U_0$ von einigen kV, beispielsweise im Bereich von 1 bis 10 kV, und einer maximalen Stromamplitude $I_0$ von einigen kA bis > 10 kA. Um die Addition der Spannungsamplituden zu bewirken, wird die Vektoraddition der elektromagnetischen Felder im Übergangsbereich zur koaxialen Transmissionsleitung ausgenutzt. Damit generiert der IVA einen Spannungsimpuls, der sich aus der Summe der n (n: Anzahl der Stufen) einzelnen Spannungsquellen überlagert. Entsprechend erzeugt eine Anordnung gemäß Figur 2 einen sechsfachen Spannungsimpuls. Um die Addition der Spannungsamplituden zu bewirken, wird der positive Leiter der einen Spannungsquelle mit der negativen der Folgenden verbunden. Dadurch wird in jeder Kavität zwangsläufig eine leitende Verbindung zwischen Mittelelektrode und der stromabgelegenen Außenelektrode hergestellt. Um zu verhindern, dass auf diese Weise ein Kurzschluss im Ausgang der Leitung entsteht, wird die Impedanz der Verbindung durch Erhöhung der relativen Permeabilität in diesem Abschnitt stark vergrößert. Dazu wird ein Teilvolumen der Spannungsquelle mit Ringbandkernen aus ferromagnetischem Material gefüllt.

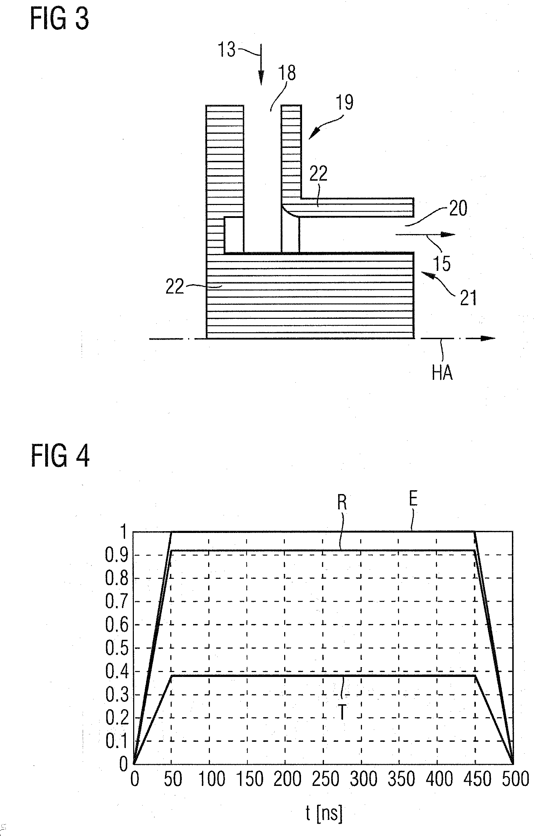

Figur 3 zeigt ein herkömmliches Ausführungsbeispiel einer ersten Stufe. Figur 3 zeigt einen um eine Wellenausbreitungshauptachse HA rotationssymmetrischen Ausschnitt eines herkömmlichen Simulationsmodells. Dabei wird ein Signal in einen Anschluss 13 (oder Port) eingespeist und zu einem Anschluss 15 weitergeführt. Die Führung erfolgt entlang eines hohlzylindrischen Kanals 18 einer radialen Transmissionsleitung 19 in einen hohlzylindrischen Kanal 20 einer Koaxialleitung oder koaxialen Transmissionleitung 21 und entlang dieser. Die Kanäle 18 und 20 sind mittels Wänden begrenzt und geschaffen, die ein elektrisch leitendes Material 22 aufweisen.

Figur 4 zeigt mit der oberen Kurve den zeitlichen Verlauf eines Einspeisesignals E, mit dessen mittlerer Kurve den zeitlichen Verlauf dessen reflektierten Signalanteils R und mit dem unteren Signalverlauf die transmittierten Signalanteile T. Bei einem derartigen Aufbau sind die nicht gezeigten Impulserzeugungsmodule als Anschluss 13 gekennzeichnet. Diese Geometrie hat den Vorteil, dass sie geometrisch weitgehend mit den nachfolgenden Stufen identisch ist. Den Simulationsergebnissen, insbesondere gemäß Figur 4, ist jedoch zu entnehmen, dass die erste Kopplungs-beziehungsweise Transformatorstufe erhebliche Reflexionen des Eingangssignals aufweist, was in der Realität zu einer massiv höheren Eingangsleistung führen würde, um die nötige Ausgangsleistung an dem Anschluss 15 zur Verfügung zu stellen. Eine derartige herkömmliche Lösung ist daher technisch sehr ungünstig, da die Anschluss 13-Module elektrisch stark von den in den nachfolgenden Stufen verwendeten Modulen abweichen müssen.

Eine erste Stufe eines IVA wird daher herkömmlicherweise meist über eine koaxiale Einspeisung realisiert, wodurch die erste Stufe geometrisch als auch elektrisch deutlich von den folgenden Stufen abweicht. Bei den bekannten Lösungen sind daher die Komplexität der Anordnung und somit auch deren Kosten hoch.

Aus dem Zeitschriftenartikel Kohno, S. et al., High-current pulsed power generator ASO-X using inductive voltage adder and inductive energy storage system, Japanese journal of applied physics, Japanese society of applied physics, JP , Mai 2000, Band 39, Nr. 5A, part 01, Seiten 2829-2833, ist eine Vorrichtung zur Erzeugung von Hochspannungspulsen bekannt, die auf einem induktiven Spannungsaddierer basiert. Um die Spannung und die Leistung der Einrichtung zu erhöhen und eine Anstiegszeit des Stroms zu verringern, wird ein plasmabasierter Leistungsschalter verwendet.

Der Zeitschriftenartikel Thomas, K. J. et al., LINX and future IVA machines, Proc. IEE Pulsed Power' 99, April 1999, Seiten 2/1-2/4, offenbart einen induktiven Spannungsaddierer mit einem modularen Ansatz zum Erreichen von hohen Beschleunigungsspannungen für einen Elektronenstrahl. Durch die Nutzung eines induktiven Spannungsaddi-erers kann die Komponentengröße reduziert werden und eine Impedanzanpassung an in der Radiographie genutzte Elektronenstrahldioden verbessert werden.

Es ist damit Aufgabe der vorliegenden Erfindung, eine geeignete geometrische Anordnung einer ersten Stufe eines induktiven Spannungsaddierers (IVA) anzugeben, welche nach Möglichkeit mit den gleichen Submodulen realisiert werden kann, die in den nachfolgenden Stufen zur Impulserzeugung eingesetzt werden. Es soll ebenso ein entsprechendes Verfahren zur Impulsanpassung bereitgestellt werden.

Die Aufgabe wird durch eine Vorrichtung gemäß dem Hauptanspruch und einem Verfahren gemäß dem Nebenanspruch gelöst.

Gemäß einem ersten Aspekt wird eine Vorrichtung zur Erzeugung von Hochspannungsimpulsen, insbesondere ein induktiver Spannungsaddierer, beansprucht, wobei während der Pulserzeugung elektromagnetische Felder einer Serien-Schaltung einer Anzahl n diskreter entlang einer Wellenausbreitungshauptachse angeordneter Stufen von Spannungsquellen in einem Transformator kombiniert werden, wobei in jeder Stufe sich Wellen jeweils entlang einer einen ersten Wellenwiderstand aufweisenden radialen Transmissionsleitung in eine einen zweiten Wellenwiderstand aufweisenden koaxiale Transmissionsleitung ausbreiten, dadurch gekennzeichnet, dass in der ersten Stufe im Unterschied zu den folgenden Stufen mittels eines stetigen und kontinuierlichen Übergangsbereichs von der radialen Transmissionsleitung in die koaxiale Transmissionsleitung ein stetiger und kontinuierlicher Übergang von dem ersten Wellenwiderstand zu dem zweiten Wellenwiderstand geschaffen ist.

Gemäß einem zweiten Aspekt wird ein Verfahren zur Erzeugung von Hochspannungsimpulsen, insbesondere ein induktiver Spannungsaddierer, beansprucht, wobei während der Pulserzeugung elektromagnetische Felder einer Serien-Schaltung einer Anzahl n diskreter entlang einer Wellenausbreitungshauptachse angeordneter Stufen von Spannungsquellen in einem Transformator kombiniert werden, wobei in jeder Stufe sich Wellen jeweils entlang einer einen ersten Wellenwiderstand aufweisenden radialen Transmissionsleitung in eine einen zweiten Wellenwiderstand aufweisenden koaxiale Transmissionsleitung ausbreiten, dadurch gekennzeichnet, dass in der ersten Stufe im Unterschied zu den folgenden Stufen mittels eines stetigen und kontinuierlichen Übergangsbereichs von der radialen Transmissionsleitung in die koaxiale Transmissionsleitung ein stetiger und kontinuierlicher Übergang von dem ersten Wellenwiderstand zu dem zweiten Wellenwiderstand geschaffen ist.

Erfindungsgemäß wird ein Pulsgenerator erzeugt und verwendet, der so kompakt und kostengünstig wie möglich gestaltbar ist. Gemäß der vorliegenden Erfindung wird eine Ausführung der ersten Transformatorstufe vorgeschlagen, wobei mittels der vorgeschlagenen Geometrie es möglich ist, alle Anpassnetzwerke, Schalter, Kondensatoren und Treiberschaltungen modular zu allen anderen Transformatorstufen zu wählen. Auf diese Weise ist zwischen der ersten und den folgenden Transformator-Stufen nun ein modularer Aufbau möglich. Eine modulare Bauweise eines IVA senkt die Kosten und ermöglicht gleichzeitig eine kompaktere Bauform. Erfindungsgemäß wird eine Ausführung einer ersten Transformatorstufe des IVA vorgeschlagen, bei der eine Transmission der elektromagnetischen Welle über eine radiale Transmissionsleitung in eine koaxiale Transmissionsleitung erfolgt. Diese beiden Leitungen werden mittels eines trichterförmigen Zwischenstücks (Taper) miteinander verbunden. Mittels der vorgeschlagenen Ausführungsform einer ersten Stufe eines IVA wird die Leistung reflexionsfrei in die erste Stufe eingespeist. Im Bereich einer Ankopplung der Impulserzeugungsmodule (erster Anschluss 13) erhält man hier ebenfalls eine radiale Anordnung wie in den nachfolgenden Stufen. Aufgrund der reflexionsfreien Ankopplung an die zweite Stufe kann in der ersten Stufe mit derselben elektrischen Leistung gearbeitet werden, wie in den nachfolgenden Stufen. Auf diese Weise können auch in der ersten Stufe dieselben Module verwendet werden, wie in allen folgenden Stufen, was die Komplexität, Zuverlässigkeit und Kosten einer solchen Anlage deutlich verringert. Auf diese Weise kann eine Optimierung des Gesamtsystems hinsichtlich seiner Modularität und seines Bauvolumens erfolgen. Des Weiteren können die Gesamtkosten für ein derartiges System wirksam reduziert werden.

Weitere vorteilhafte Ausgestaltungen werden in Verbindung mit den Unteransprüchen beansprucht.

Gemäß einer vorteilhaften Ausgestaltung kann der kontinuierliche Übergang in der ersten Stufe mittels des ersten Wellenwiderstands der radialen Transmissionsleitung und eines Innen- und eines Außenradius der koaxialen Transmissionsleitung sowie eines Feldwellenwiderstands geschaffen werden.

Gemäß einer weiteren vorteilhaften Ausgestaltung können im Übergangsbereich der ersten Stufe sich quer zur Wellenausbreitungshauptachse erstreckende Wände der radialen Transmissionsleitung stetig, entlang kurviger Verläufe, rotationssymmetrisch zur Wellenausbreitungshauptachse in längs zu dieser sich erstreckende Wände der koaxialen Transmissionsleitung übergehen.

Gemäß einer weiteren vorteilhaften Ausgestaltung kann im Übergangsbereich der ersten Stufe eine erste räumliche Materialerstreckung geschaffen sein, die kreisförmige und zu der Wellenausbreitungshauptachse HA senkrechte Querschnittsflächen aufweist, deren Radien entlang und in Richtung der Richtung der Wellenausbreitungshauptachse beginnend von dem Außenradius des Außenleiters auf den Außenradius des Innenleiters der koaxialen Transmissionsleitung stetig fallend verkleinernd erzeugt sind. Eine räumliche Materialerstreckung ist insbesondere ein allgemeiner ein Material aufweisender dreidimensionaler physikalischer Körper oder Bereich eines derartigen Körpers.

"Entlang und in Richtung der Richtung der Wellenausbreitungshauptachse (HA)" bedeutet hier "entlang der Wellenausbreitungshauptachse (HA) und in Richtung der Richtung der Wellenausbreitungshauptachse (HA)" und insbesondere "parallel zur Wellenausbreitungshauptachse verlaufend, und zwar in die Richtung, in die die Wellenausbreitungshauptachse zeigt". Diese Richtung ist die Richtung, in die die Wellen sich hauptsächlich ausbreiten.

Gemäß einer weiteren vorteilhaften Ausgestaltung kann im Übergangsbereich Ü der ersten Stufe eine zweite räumlichen Materialerstreckung geschaffen sein, die kreisringförmige und zu der Wellenausbreitungshauptachse senkrechte Querschnittsflächen aufweist, deren äußere Radien konstant und deren innere Radien entlang und in Richtung der Richtung der Wellenausbreitungshauptachse beginnend von dem äußeren Radius auf den Innenradius des Außenleiters der koaxialen Transmissionsleitung (21) stetig fallend verkleinernd erzeugt sind.

Gemäß einer weiteren vorteilhaften Ausgestaltung können die Radien der Querschnittflächen der ersten räumlichen Materialerstreckung und/oder die inneren Radien der Querschnittsflächen der zweiten räumlichen Materialerstreckung ausgehend von der Seite der radialen Transmissionsleitung in Richtung zu der Seite der koaxialen Transmissionsleitung exponentiell fallend verkleinernd erzeugt sein.

Gemäß einer weiteren vorteilhaften Ausgestaltung können die Radienverläufe der Radien der Querschnittflächen der erste räumlichen Materialerstreckung und der inneren Radien der Querschnittfläche der zweiten räumlichen Materialerstreckung ausgehend von der Seite der radialen Transmissionsleitung in Richtung zu der Seite der koaxialen Transmissionsleitung zueinander parallel verlaufend erzeugt sein.

Gemäß einer weiteren vorteilhaften Ausgestaltung kann die erste räumliche Materialerstreckung als ein massives separates Zwischenstück geschaffen sein.

Gemäß einer weiteren vorteilhaften Ausgestaltung kann das Zwischenstück entlang und in Richtung der Richtung der Wellenausbreitungshauptachse (HA) einen Außenflächenverlauf einer massiven, insbesondere sich radial verjüngenden, Trichterform aufweist.

Gemäß einer weiteren vorteilhaften Ausgestaltung können die erste und die zweite räumliche Materialerstreckung das gleiche Material, insbesondere Kupfer, Stahl oder Aluminium aufweisen.

Gemäß einer weiteren vorteilhaften Ausgestaltung können alle n Stufen hinsichtlich deren elektrotechnischen Verschaltung oder deren elektrischen Anschlüssen einen gleichen modularen Aufbau aufweisen.

Die Erfindung wird anhand von Ausführungsbeispielen in Verbindung mit den Figuren näher beschrieben. Es zeigen:

Figur 1     ein herkömmliches Ausführungsbeispiel eines IVA;

Figur 2     ein weiteres herkömmliches Ausführungsbeispiel eines IVA;

Figur 3     ein herkömmliches Ausführungsbeispiel einer ersten Transformatorstufe eines IVA

Figur 4     eine Darstellung zur Simulation des herkömmlichen Ausführungsbeispiels der ersten Transformatorstufe;

Figur 5    ein erfindungsgemäßes Ausführungsbeispiel einer ersten Transformatorstufe eines IVA;

Figur 6    die Signalverläufe zum erfindungsgemäßen Ausführungsbeispiel einer ersten Transformatorstufe eines IVA;

Figur 7    eine Darstellung zu den elektrischen Feldern einer erfindungsgemäßen ersten Stufe eines IVA;

Figur 8    eine Darstellung von magnetischen Feldern des erfindungsgemäßen Ausführungsbeispiels einer ersten Stufe eines IVA;

Figur 9    eine weitere Darstellung zum erfindungsgemäßen Ausführungsbeispiel einer ersten Stufe eines IVA.

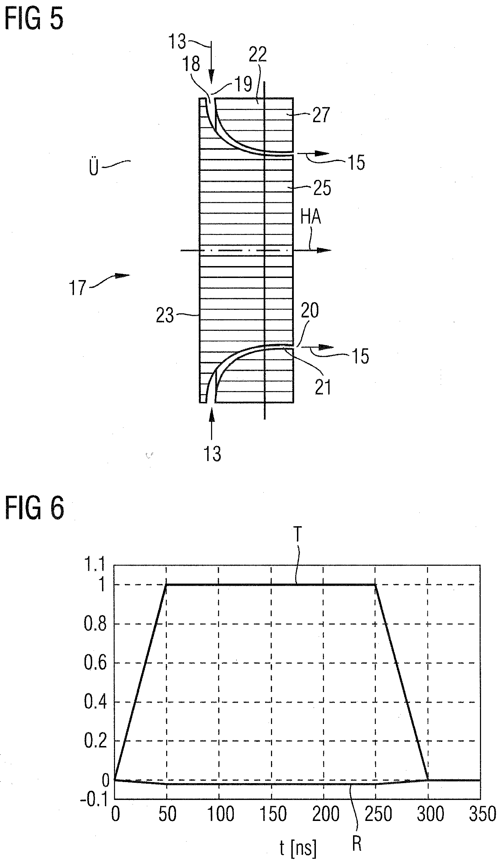

Figur 5 zeigt ein erstes erfindungsgemäßes Ausführungsbeispiel einer ersten Stufe eines IVA (induktiver Spannungsaddierer), wobei diese erste Stufe sich entlang einer Wellenausbreitungshauptachse HA rotationssymmetrisch erstreckt. Analog zu Figur 3 wird ein Signal in einem ersten Anschluss 13 eingespeist und zu einem zweiten Anschluss 15 weitergeführt.

In dieser ersten Stufe 17 erfolgt zuerst eine Transmission der elektromagnetischen Wellen entlang einer radialen Transmissionsleitung 19 und danach entlang einer koaxialen Transmissionsleitung 21. Die Führung erfolgt entlang der hier vertikalen hohlzylindrischen Transmissionsleitung 19 in die hier horizontale hohlzylindrische Koaxialleitung 21, die an einer äußeren Seite einen Außenleiter 27 und an einer inneren Seite einen Innenleiter 25 aufweist.

Ein Übergangsbereich Ü leitet einen hohlzylindrischen Kanal 18 der sich quer zur Wellenausbreitungshauptachse HA erstreckenden radialen Transmissionsleitung 19 entlang kurvenförmig begrenzender Oberflächen elektrisch leitenden Materials 22 stetig, entlang kurviger Verläufe homogen in einen hohlzylindrischen Kanal 20 der sich längs der Wellenausbreitungshauptachse HA erstreckenden koaxialen Transmissionsleitung 21 über.

Entlang eines Übergangs von der radialen Transmissionsleitung 19 in die koaxiale Transmissionsleitung 21 ist hier ein massives Zwischenstück 23 positioniert. Dieses Zwischenstück 23 erstreckt sich räumlich bevorzugt mit kreisförmigen Querschnittsflächen rotationssymmetrisch zu und entlang der Wellenausbreitungshauptachse HA, von einer einen ersten Radius aufweisenden ersten äußere Kreisfläche, bis zu einer einen zweiten, zum ersten Radius kleineren, Radius aufweisenden zweiten äußeren Kreisfläche. Der zweite Radius ist dabei bevorzugt gleich dem Außenradius des Innenleiters 25 und damit gleich dem Innenradius der hohlzylindrischen Koaxialleitung 21. Zudem ist es bevorzugt, wenn zwischen dem Außenleiter 27, der die hohlzylindrische Koaxialleitung 21 nach außen begrenzt, und einem den Außenleiter 27 kontaktierenden dazugehörigen Material 22 , im Übergangsbereich Ü eine zweite räumlichen Materialerstreckung geschaffen ist, die kreisringförmige und zu der Wellenausbreitungshauptachse HA senkrechte Querschnittsflächen aufweist, deren äußere Radien konstant und deren innere Radien entlang und in Richtung der Wellenausbreitungshauptachse HA beginnend von dem äußeren Radius auf den Innenradius des Außenleiters der koaxialen Transmissionsleitung 21 stetig fallend verkleinernd erzeugt sind. Die Radien und/oder die inneren Radien der Querschnittsflächen ausgehend von der Seite der radialen Transmissionsleitung 19 in Richtung zu der Seite der koaxialen Transmissionsleitung 21 können exponentiell fallend verkleinernd erzeugt sind. Bevorzugt sind die Radienverläufe der Radien und/oder inneren Radien der Querschnittsflächen der ersten und der zweiten räumlichen Materialerstreckung ausgehend von der Seite der radialen Transmissionsleitung 19 in Richtung zu der Seite der koaxialen Transmissionsleitung 21 zueinander parallel verlaufend erzeugt.

Das massive Zwischenstück 23 weist beispielsweise die Form eines massiven Trichters auf, koppelt die radiale mit der koaxialen Transmissionsleitung und kann ebenso als Taper bezeichnet werden. Das Zwischenstück 23 kann ebenso in einer nicht massiven Bauform hergestellt werden, beispielsweise als ein Trichter mit einer Durchgangsöffnung oder einem Loch. Besonders vorteilhaft sind die Wellenwiderstände der radialen Transmissionsleitung und der koaxialen Transmissionsleitung aufeinander abgestimmt. Ein erster Wellenwiderstand einer radialen Leitung kann mittels Gleichung

(1)

$$Z_{Radial} = Z_0 \cdot \frac{G_0(kr)}{G_1(kr)}$$

beschrieben werden. Dabei ist k der Wellenzahlvektor, $Z_0$ ist der Feldwellenwiderstand mit einer Größe von 377 Ω und $G_0$ (kr), $G_1$ (kr) sind Funktionene, die ähnlich zu Hanke und durch Holland definiert sind.

Ein zweiter Wellenwiderstand einer Koaxialleitung lässt sich beispielsweise durch folgende Gleichung

$$(2)$$

$$Z_{Radial} = Z_0 \cdot \frac{Z_0}{2\pi\sqrt{s_r}} \, ln\left(\frac{R_2}{R_1}\right)$$

beschreiben. Dabei ist $R_1$ der innere Radius der Koaxialleitung, $R_2$ ist der äußere Radius der Koaxialleitung und $Z_0$ ist der Feldwellenwiderstand mit einer Größe von 377 Q. $R_1$ ist ebenso der Radius des Innenleiters 25. $R_2$ ist ebenso der Innenradius des Außenleiters 27. Anhand dieser Gleichungen (1) und (2) ist ein Einfluss des Wellenwiderstands erkennbar. Erfindungsgemäß sollen mittels geschickten Verbindens der radialen Transmissionsleitung 19 mit der koaxialen Transmissionsleitung 21 in Form einer trichterförmigen Struktur, beide Wellenwiderstände aneinander angeglichen werden. Auf diese Weise ist eine reflexionsfreie Einspeisung von der radialen Transmissionsleitung 19 in die koaxiale Transmissionsleitung 21 und in die koaxiale Struktur des IVA möglich.

Figur 6 zeigt einen zeitlichen Verlauf eines reflektierten Signals R und eines transmittierten Signals T im Zeitbereich bei Verwendung einer erfindungsgemäßen ersten Stufe eines IVA. Diese Simulation zeigt Reflexionen R, bedingt durch eine Näherung, von unter 2 %. Eine Anpassung von radialer Transmissionsleitung 19 und koaxialer Transmissionsleitung 21 lässt sich ebenso mittels exponentieller Funktionen, die beide Leitungen miteinander verbinden, erzielen. Derartige exponentielle Funktionen müssen die Eigenschaft aufweisen, dass die Strukturen stetig ineinander übergehen.

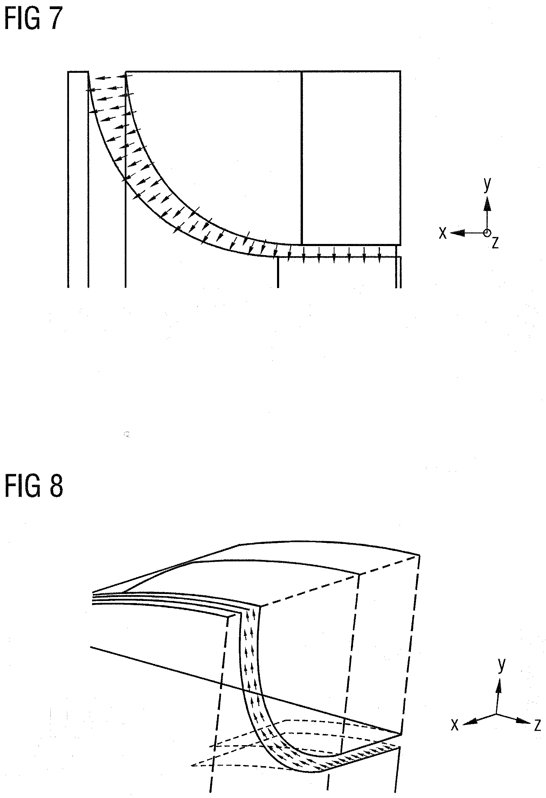

Figur 7 zeigt eine Darstellung des Verlaufs der elektrischen Felder in einer erfindungsgemäßen ersten Stufe eines IVA. Pfeile stellen ein Vektorfeld dar.

Figur 8 zeigt eine Darstellung von magnetischen Feldern in einer erfindungsgemäßen ersten Stufe eines IVA. Pfeile stellen ein Vektorfeld dar.

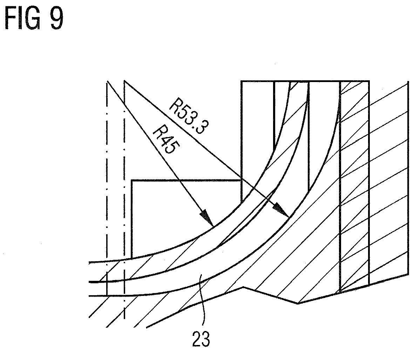

Figur 9 zeigt eine weitere Ansicht eines erfindungsgemäßen trichterförmigen Zwischenstücks 23. Dabei erfolgt eine Anpassung dieses Zwischenstücks 23 beziehungsweise Tapers an die unterschiedlichen Leiterstrukturen mittels der Wahl unterschiedlicher Innen- und Außenradien von der radialen Transmissionsleitung 19 zu der koaxialen Transmissionsleitung 21. Figur 9 zeigt beispielsweise einen Außenradius R des Außenleiters 27 mit einer Größe von 53,5 und einen Radius $R_1$ des Innenleiters 25 mit einer Größe von R=45. Figur 9 zeigt eine Anpassung der radialen Transmissionsleitung 19 und der koaxialen Transmissionsleitung 21, die mittels des trichterförmigen Zwischenstücks 23 verbunden sind, wobei dessen Innen- und Außenradius entlang der Verbindung variiert. In der Praxis ist es ausreichend, die radiale Transmissionsleitung 19 und die koaxiale Transmissionsleitung 21 mit zwei verschiedenen Radien zu verbinden.

Die vorliegende Erfindung betrifft eine Vorrichtung und ein Verfahren zur Erzeugung von Hochspannungsimpulsen, insbesondere mittels eines induktiven Spannungsaddierers IVA, wobei in der ersten Stufe 17 zur Transmission von elektromagnetischen Wellen von einer radialen Transmissionsleitung 19 in die koaxiale Transmissionsleitung 21 zwischen der radialen Transmissionsleitung 19 und der koaxialen Transmissionsleitung 21 ein elektromagnetisch koppelndes, trichterförmiges Zwischenstück 23, positioniert ist.

## Patentansprüche

1. Vorrichtung zur Erzeugung von Hochspannungsimpulsen, insbesondere ein induktiver Spannungsaddierer (IVA), wobei während der Pulserzeugung elektromagnetische Felder einer Serien-Schaltung einer Anzahl n diskreter entlang einer Wellenausbreitungshauptachse (HA) angeordneter Stufen von Spannungsquellen in einem Transformator kombiniert werden, wobei in jeder Stufe sich Wellen jeweils entlang einer einen ersten Wellenwiderstand aufweisenden radialen Transmissionsleitung (19) in eine einen zweiten Wellenwiderstand aufweisenden koaxiale Transmissionsleitung (21) ausbreiten, **dadurch gekennzeichnet, dass** in der ersten Stufe (17) im Unterschied zu den folgenden Stufen mittels eines stetigen und kontinuierlichen Übergangsbereichs (Ü) von der radialen Transmissionsleitung (19) in die koaxiale Transmissionsleitung (21) ein kontinuierlicher Übergang von dem ersten Wellenwiderstand zu dem zweiten Wellenwiderstand geschaffen ist.

2. Vorrichtung nach Anspruch 1, **dadurch gekennzeichnet, dass** der kontinuierliche Übergang in der ersten Stufe (17) mittels des ersten Wellenwiderstands der radialen Transmissionsleitung (19) und eines Innen- und eines Außenradius der koaxialen Transmissionsleitung (21) sowie eines Feldwellenwiderstands geschaffen ist.

3. Vorrichtung nach Anspruch 1 oder 2, **dadurch gekennzeichnet, dass** im Übergangsbereich (Ü) der ersten Stufe (17) sich quer zur Wellenausbreitungshauptachse (HA) erstreckende Wände der radialen Transmissionsleitung (19) stetig, entlang kurviger Verläufe, rotationssymmetrisch zur Wellenausbreitungshauptachse (HA) in längs zu dieser sich erstreckende Wände der koaxialen Transmissionsleitung (21) übergehen.

4. Vorrichtung nach Anspruch 3, **dadurch gekennzeichnet, dass** im Übergangsbereich (Ü) der ersten Stufe (17) eine erste räumlichen Materalerstreckung geschaffen ist, die kreisförmige und zu der Wellenausbreitungshauptachse (HA) senkrechte Querschnittsflächen aufweist, deren Radien entlang und in Richtung der Richtung der Wellenausbreitungshauptachse (HA) beginnend von dem Außenradius des Außenleiters (27) auf den Außenradius des Innenleiters (25) der koaxialen Transmissionsleitung (21) stetig fallend verkleinernd erzeugt sind.

5. Vorrichtung nach Anspruch 4, **dadurch gekennzeichnet, dass** die Radien der Querschnittflächen der ersten räumlichen Materalerstreckung ausgehend von der Seite der radialen Transmissionsleitung (19) in Richtung zu der Seite der koaxialen Transmissionsleitung(21) exponentiell fallend verkleinernd erzeugt sind.

6. Vorrichtung nach Anspruch 3, 4 oder 5, **dadurch gekennzeichnet, dass** im Übergangsbereich (Ü) der ersten Stufe (17) eine zweite räumlichen Materalerstreckung geschaffen ist, die kreisringförmige und zu der Wellenausbreitungshauptachse (HA) senkrechte Querschnittsflächen aufweist, deren äußere Radien konstant und deren innere Radien entlang und in Richtung der Richtung der Wellenausbreitungshauptachse (HA) beginnend von dem äußeren Radius auf den Innenradius des Außenleiters (27) der koaxialen Transmissionsleitung (21) stetig fallend verkleinernd erzeugt sind.

7. Vorrichtung nach Anspruch 6, **dadurch gekennzeichnet, dass** die inneren Radien der Querschnittflächen der zweiten räumlichen Materalerstreckung ausgehend von der Seite der radialen Transmissionsleitung (19) in Richtung zu der Seite der koaxialen Transmissionsleitung(21) exponentiell fallend verkleinernd erzeugt sind.

8. Vorrichtung nach Anspruch 6 oder 7, **dadurch gekennzeichnet, dass** die Radienverläufe der Radien der Querschnittflächen der erste räumlichen Materalerstreckung und der inneren Radien der Querschnittflächen der zweiten räumlichen Materalerstreckung ausgehend von der Seite der radialen Transmissionsleitung (19) in Richtung zu der Seite der koaxialen Transmissionsleitung(21) zueinander parallel verlaufend erzeugt sind.

9. Vorrichtung nach einem der vorhergehenden Ansprüche 4 bis 8, **dadurch gekennzeichnet, dass** die erste räumliche Materalerstreckung als ein separates Zwischenstück (23) geschaffen ist.

10. Vorrichtung nach Ansprüche 9, **dadurch gekennzeichnet, dass** das Zwischenstück (23) entlang und in Richtung der Richtung der Wellenausbreitungshauptachse (HA) einen Außenflächenverlauf eines sich verjüngenden Trichters aufweist.

11. Vorrichtung nach einem der vorhergehenden Ansprüche 6 bis 10, **dadurch gekennzeichnet, dass** die erste und die zweite räumliche Materalerstreckung das gleiche Material, insbesondere Kupfer, Stahl oder Aluminium aufweisen.

12. Vorrichtung nach einem der vorhergehenden Ansprüche, **dadurch gekennzeichnet, dass** alle n Stufen hinsichtlich deren elektrotechnischen Verschaltung einen gleichen modularen Aufbau aufweisen.

13. Verfahren zur Erzeugung von Hochspannungsimpulsen, insbesondere mittels eines induktiven Spannungsaddierers (IVA), wobei während der Pulserzeugung elektromagnetische Felder einer Serien-Schaltung einer Anzahl n diskreter entlang einer Wellenausbreitungshauptachse (HA) angeordneter Stufen von Spannungsquellen in einem Transformator kombiniert werden, wobei in jeder Stufe sich Wellen jeweils entlang einer einen ersten Wellenwiderstand aufweisenden radialen Transmissionsleitung (19) in eine einen zweiten Wellenwiderstand aufweisenden koaxiale Transmissionsleitung (21) ausbreiten, **dadurch gekennzeichnet, dass** in der ersten Stufe (17) im Unterschied zu den folgenden Stufen mittels eines stetigen und kontinuierlichen Übergangsbereichs (Ü) von der radialen Transmissionsleitung (19) in die koaxialen Transmissionsleitung (21) ein kontinuierlicher Übergang von dem ersten Wellenwiderstand zu dem zweiten Wellenwiderstand geschaffen ist.

14. Verfahren nach Anspruch 13, **dadurch gekennzeichnet, dass** der kontinuierliche Übergang in der ersten Stufe (17) mittels des ersten Wellenwiderstands der radialen Transmissionsleitung (19) und eines Innen- und eines Außenradius der koaxialen Transmissionsleitung (21) sowie eines Feldwellenwiderstands geschaffen ist.

15. Verfahren nach Anspruch 13 oder 14, **dadurch gekennzeichnet, dass** im Übergangsbereich (Ü) der ersten Stufe (17) sich quer zur Wellenausbreitungshauptachse (HA) erstreckende Wände der radialen Transmissionsleitung (19) stetig, entlang kurviger Verläufe, rotationssymmetrisch zur Wellenausbreitungshauptachse (HA) in längs zu dieser sich erstreckende Wände der koaxialen Transmissionsleitung (21) übergehen.

**16.** Verfahren nach Anspruch 14, **dadurch gekennzeichnet, dass** im Übergangsbereich (Ü) der ersten Stufe (17) eine erste räumlichen Materialerstreckung geschaffen ist, die kreisförmige und zu der Wellenausbreitungshauptachse (HA) senkrechte Querschnittsflächen aufweist, deren Radien entlang und in Richtung der Richtung der Wellenausbreitungshauptachse (HA) beginnend von dem Außenradius des Außenleiters (27) auf den Außenradius des Innenleiters (25) der koaxialen Transmissionsleitung (21) stetig fallend verkleinernd erzeugt sind.

**17.** Verfahren nach Anspruch 16, **dadurch gekennzeichnet, dass** die Radien der Querschnittflächen der ersten räumlichen Materialerstreckung ausgehend von der Seite der radialen Transmissionsleitung (19) in Richtung zu der Seite der koaxialen Transmissionsleitung(21) exponentiell fallend verkleinernd erzeugt sind.

**18.** Verfahren nach Anspruch 15, 16 oder 17, **dadurch gekennzeichnet, dass** im Übergangsbereich (Ü) der ersten Stufe (17) eine zweite räumlichen Materialerstreckung geschaffen ist, die kreisringförmige und zu der Wellenausbreitungshauptachse (HA) senkrechte Querschnittsflächen aufweist, deren äußere Radien konstant und deren innere Radien entlang und in Richtung der Richtung der Wellenausbreitungshauptachse (HA) beginnend von dem äußeren Radius auf den Innenradius des Außenleiters (27) der koaxialen Transmissionsleitung (21) stetig fallend verkleinernd erzeugt sind.

**19.** Verfahren nach Anspruch 18, **dadurch gekennzeichnet, dass** die inneren Radien der Querschnittflächen der zweiten räumlichen Materialerstreckung ausgehend von der Seite der radialen Transmissionsleitung (19) in Richtung zu der Seite der koaxialen Transmissionsleitung(21) exponentiell fallend verkleinernd erzeugt sind.

**20.** Verfahren nach Anspruch 18 oder 19, **dadurch gekennzeichnet, dass** die Radienverläufe der Radien der Querschnittflächen der erste räumlichen Materialerstreckung und der inneren Radien der Querschnittflächen der zweiten räumlichen Materialerstreckung ausgehend von der Seite der radialen Transmissionsleitung (19) in Richtung zu der Seite der koaxialen Transmissionsleitung(21) zueinander parallel verlaufend erzeugt sind.

**21.** Verfahren nach einem der vorhergehenden Ansprüche 16 bis 20, **dadurch gekennzeichnet, dass** die erste räumliche Materialerstreckung als ein separates Zwischenstück (23) geschaffen ist.

**22.** Verfahren nach Ansprüche 21, **dadurch gekennzeichnet, dass** das Zwischenstück (23) entlang und in Richtung der Richtung der Wellenausbreitungshauptachse (HA) einen Außenflächenverlauf eines sich verjüngenden Trichters aufweist.

**23.** Verfahren nach einem der vorhergehenden Ansprüche 18 bis 22, **dadurch gekennzeichnet, dass** die erste und die zweite räumliche Materialerstreckung das gleiche Material, insbesondere Kupfer, Stahl oder Aluminium aufweisen.

**24.** Verfahren nach einem der vorhergehenden Ansprüche 13 bis 23, **dadurch gekennzeichnet, dass** alle n Stufen hinsichtlich deren elektrotechnischen Verschaltung einen gleichen modularen Aufbau aufweisen.

**Claims**

**1.** Apparatus for generating high-voltage pulses, in particular an inductive voltage adder (IVA), wherein, during pulse generation, electromagnetic fields of a series circuit of a number n of discrete stages of voltage sources which are arranged along a wave propagation main axis (HA) are combined in a transformer, wherein, in each stage, waves respectively propagate along a radial transmission line (19) having a first characteristic impedance into a coaxial transmission line (21) having a second characteristic impedance, **characterized in that**, in contrast to the subsequent stages, a continuous transition from the first characteristic impedance to the second characteristic impedance is created in the first stage (17) using a steady and continuous transition region (U) from the radial transmission line (19) to the coaxial transmission line (21).

**2.** Apparatus according to Claim 1, **characterized in that** the continuous transition in the first stage (17) is created by means of the first characteristic impedance of the radial transmission line (19) and an inner radius and an outer radius of the coaxial transmission line (21) as well as a field characteristic impedance.

**3.** Apparatus according to Claim 1 or 2, **characterized in that**, in the transition region (Ü) of the first stage (17), walls of the radial transmission line (19) which extend transversely with respect to the wave propagation main axis (HA) continuously merge into walls of the coaxial transmission line (21) which extend longitudinally with respect to the wave propagation main axis (HA) along winding profiles in a rotationally symmetrical manner with respect to the wave propagation main axis (HA).

4. Apparatus according to Claim 3, **characterized in that** a first spatial material extent is created in the transition region (Ü) of the first stage (17), said material extent having circular cross-sectional areas which are perpendicular to the wave propagation main axis (HA) and the radii of which are produced in a diminishing manner such that they fall continuously starting from the outer radius of the outer conductor (27) to the outer radius of the inner conductor (25) of the coaxial transmission line (21) along and in the direction of the direction of the wave propagation main axis (HA).

5. Apparatus according to Claim 4, **characterized in that** the radii of the cross-sectional areas of the first spatial material extent are produced in a diminishing manner such that they fall exponentially starting from the side of the radial transmission line (19) in the direction of the side of the coaxial transmission line (21).

6. Apparatus according to Claim 3, 4 or 5, **characterized in that** a second spatial material extent is created in the transition region (Ü) of the first stage (17), said material extent having circular cross-sectional areas which are perpendicular to the wave propagation main axis (HA) and the outer radii of which are produced in a constant manner and the inner radii of which are produced in a diminishing manner such that they fall continuously starting from the outer radius to the inner radius of the outer conductor (27) of the coaxial transmission line (21) along and in the direction of the direction of the wave propagation main axis (HA).

7. Apparatus according to Claim 6, **characterized in that** the inner radii of the cross-sectional areas of the second spatial material extent are produced in a diminishing manner such that they fall exponentially starting from the side of the radial transmission line (19) in the direction of the side of the coaxial transmission line (21).

8. Apparatus according to Claim 6 or 7, **characterized in that** the radius profiles of the radii of the cross-sectional areas of the first spatial material extent and of the inner radii of the cross-sectional areas of the second spatial material extent are produced in a manner running parallel to one another starting from the side of the radial transmission line (19) in the direction of the side of the coaxial transmission line (21).

9. Apparatus according to one of the preceding Claims 4 to 8, **characterized in that** the first spatial material extent is created as a separate intermediate piece (23).

10. Apparatus according to Claim 9, **characterized in that** the intermediate piece (23) has an outer surface profile of a tapering funnel along and in the direction of the wave propagation main axis (HA).

11. Apparatus according to one of the preceding Claims 6 to 10, **characterized in that** the first and the second spatial material extents have the same material, in particular copper, steel or aluminum.

12. Apparatus according to one of the preceding claims, **characterized in that** all n stages have the same modular structure with respect to their electrotechnical connection.

13. Method for generating high-voltage pulses, in particular by means of an inductive voltage adder (IVA), wherein, during pulse generation, electromagnetic fields of a series circuit of a number n of discrete stages of voltage sources which are arranged along a wave propagation main axis (HA) are combined in a transformer, wherein, in each stage, waves respectively propagate along a radial transmission line (19) having a first characteristic impedance into a coaxial transmission line (21) having a second characteristic impedance, **characterized in that**, in contrast to the subsequent stages, a continuous transition from the first characteristic impedance to the second characteristic impedance is created in the first stage (17) using a steady and continuous transition region (U) from the radial transmission line (19) to the coaxial transmission line (21).

14. Method according to Claim 13, **characterized in that** the continuous transition in the first stage (17) is created by means of the first characteristic impedance of the radial transmission line (19) and an inner radius and an outer radius of the coaxial transmission line (21) as well as a field characteristic impedance.

15. Method according to Claim 13 or 14, **characterized in that**, in the transition region (Ü) of the first stage (17), walls of the radial transmission line (19) which extend transversely with respect to the wave propagation main axis (HA) continuously merge into walls of the coaxial transmission line (21) which extend longitudinally with respect to the wave propagation main axis (HA) along winding profiles in a rotationally symmetrical manner with respect to the wave propagation main axis (HA).

16. Method according to Claim 14, **characterized in that** a first spatial material extent is created in the transition region (Ü) of the first stage (17), said material extent having circular cross-sectional areas which are perpendicular to the wave propagation main axis (HA) and the radii of which are produced in a diminishing manner such that they fall continuously starting from the outer radius of the outer conductor (27) to the outer radius of the inner conductor (25) of the coaxial transmission line (21) along and in the direction of the direction of the wave propagation main axis (HA).

17. Method according to Claim 16, **characterized in that** the radii of the cross-sectional areas of the first spatial material extent are produced in a diminishing manner such that they fall exponentially starting from the side of the radial transmission line (19) in the direction of the side of the coaxial transmission line (21).

18. Method according to Claim 15, 16 or 17, **characterized in that** a second spatial material extent is created in the transition region (Ü) of the first stage (17), said material extent having circular cross-sectional areas which are perpendicular to the wave propagation main axis (HA) and the outer radii of which are produced in a constant manner and the inner radii of which are produced in a diminishing manner such that they fall continuously starting from the outer radius to the inner radius of the outer conductor (27) of the coaxial transmission line (21) along and in the direction of the direction of the wave propagation main axis (HA).

19. Method according to Claim 18, **characterized in that** the inner radii of the cross-sectional areas of the second spatial material extent are produced in a diminishing manner such that they fall exponentially starting from the side of the radial transmission line (19) in the direction of the side of the coaxial transmission line (21).

20. Method according to Claim 18 or 19, **characterized in that** the radius profiles of the radii of the cross-sectional areas of the first spatial material extent and of the inner radii of the cross-sectional areas of the second spatial material extent are produced in a manner running parallel to one another starting from the side of the radial transmission line (19) in the direction of the side of the coaxial transmission line (21) .

21. Method according to one of the preceding Claims 16 to 20, **characterized in that** the first spatial material extent is created as a separate intermediate piece (23).

22. Method according to Claim 21, **characterized in that** the intermediate piece (23) has an outer surface profile of a tapering funnel along and in the direction of the direction of the wave propagation main axis (HA).

23. Method according to one of the preceding Claims 18 to 22, **characterized in that** the first and the second spatial material extents have the same material, in particular copper, steel or aluminum.

24. Method according to one of the preceding Claims 13 to 23, **characterized in that** all n stages have the same modular structure with respect to their electrotechnical connection.

## Revendications

1. Dispositif de génération d'impulsions à haute tension, en particulier un additionneur de tension inductif (IVA), des champs électromagnétiques d'un couplage en série de n étages de sources de tension discrets positionnés le long d'un axe principal de propagation d'ondes (HA) étant combinés pendant la génération d'impulsions dans un transformateur, dans chacun desdits étages des ondes se propageant chaque fois le long d'une ligne de transmission radiale (19) comportant une première impédance caractéristique dans une ligne de transmission coaxiale (21) comportant une deuxième impédance caractéristique, **caractérisé en ce que** dans le premier étage (17) contrairement aux étages suivants, une transition continue de ladite première impédance caractéristique à ladite deuxième impédance caractéristique est créée, au moyen d'une zone de transition (Ü) régulière et continue allant de la ligne de transmission radiale (19) à la ligne de transmission coaxiale (21).

2. Dispositif selon la revendication 1, **caractérisé en ce que** la transition continue dans le premier étage (17) est créée au moyen de la première impédance caractéristique de la ligne de transmission radiale (19) et d'un rayon intérieur et extérieur de la ligne de transmission coaxiale (21) et d'une impédance d'onde caractéristique.

**3.** Dispositif selon la revendication 1 ou 2, **caractérisé en ce que** dans la zone de transition (Ü) du premier étage (17), des parois s'étendant perpendiculairement à l'axe principal de propagation d'ondes (HA) de la première ligne de transmission radiale (19) se prolongent de manière régulière, selon des allures en forme de courbe, à symétrie de révolution par rapport à l'axe principal de propagation d'ondes (HA), par des parois s'étendant longitudinalement à ce dernier de la ligne de transmission coaxiale (21).

**4.** Dispositif selon la revendication 3, **caractérisé en ce que** dans la zone de transition (Ü) du premier étage (17), une première étendue de matière spatiale est créée, laquelle présente des sections transversales de forme circulaire et perpendiculaires à l'axe principal de propagation d'ondes (HA), dont les rayons le long et dans le sens de la direction de l'axe principal de propagation d'ondes (HA), depuis le rayon extérieur du conducteur extérieur (27) vers le rayon extérieur du conducteur intérieur (25) de la ligne de transmission coaxiale (21), se réduisent et diminuent de façon régulière.

**5.** Dispositif selon la revendication 4, **caractérisé en ce que** les rayons des sections transversales de la première étendue de matière spatiale, depuis le côté de la ligne de transmission radiale (19) vers le côté de la ligne de transmission coaxiale (21), se réduisent et diminuent de façon exponentielle.

**6.** Dispositif selon la revendication 3, 4 ou 5, **caractérisé en ce que** dans la zone de transition (Ü) du premier étage (17), une deuxième étendue de matière spatiale est créée, laquelle présente des sections transversales de forme circulaire et perpendiculaires à l'axe principal de propagation d'ondes (HA), dont les rayons extérieurs sont constants et dont les rayons intérieurs le long et dans le sens de la direction de l'axe principal de propagation d'ondes (HA), depuis le rayon extérieur vers le rayon intérieur du conducteur extérieur (27) de la ligne de transmission coaxiale (27), se réduisent et diminuent de façon régulière.

**7.** Dispositif selon la revendication 6, **caractérisé en ce que** les rayons intérieurs des sections transversales de la deuxième étendue de matière spatiale, depuis le côté de la ligne de transmission radiale (19) vers le côté de la ligne de transmission coaxiale (21), se réduisent et diminuent de façon exponentielle.

**8.** Dispositif selon la revendication 6 ou 7, **caractérisé en ce que** les allures des rayons des sections transversales de la première étendue de matière spatiale et des rayons intérieurs des sections transversales de la deuxième étendue de matière spatiale, depuis le côté de la ligne de transmission radiale (19) vers le côté de la ligne de transmission coaxiale (21), sont parallèles les unes aux autres.

**9.** Dispositif selon l'une des revendications précédentes 4 à 8, **caractérisé en ce que** la première étendue de matière spatiale est réalisée sous la forme d'un élément intermédiaire (23) séparé.

**10.** Dispositif selon la revendication 9, **caractérisé en ce que** ledit élément intermédiaire (23) présente le long et dans le sens de la direction de l'axe principal de propagation d'ondes (HA) une allure des faces extérieures en forme d'entonnoir se rétrécissant.

**11.** Dispositif selon l'une des revendications précédentes 6 à 10, **caractérisé en ce que** la première et la deuxième étendue de matière spatiale sont formées de la même matière, en particulier de cuivre, d'acier ou d'aluminium.

**12.** Dispositif selon l'une des revendications précédentes, **caractérisé en ce que** concernant leur couplage électrotechnique, l'ensemble des n étages ont la même structure modulaire.

**13.** Procédé de génération d'impulsions à haute tension, en particulier au moyen d'un additionneur de tension inductif (IVA), des champs électromagnétiques d'un couplage en série de n étages de sources de tension discrets positionnés le long d'un axe principal de propagation d'ondes (HA) étant combinés pendant la génération d'impulsions dans un transformateur, dans chacun desdits étages des ondes se propageant chaque fois le long d'une ligne de transmission radiale (19) comportant une première impédance caractéristique dans une ligne de transmission coaxiale (21) comportant une deuxième impédance caractéristique, **caractérisé en ce que** dans le premier étage (17) contrairement aux étages suivants, une transition continue de ladite première impédance caractéristique à ladite deuxième impédance caractéristique est créée, au moyen d'une zone de transition (Ü) régulière et continue allant de la ligne de transmission radiale (19) à la ligne de transmission coaxiale (21).

**14.** Procédé selon la revendication 13, **caractérisé en ce que** la transition continue dans le premier étage (17) est créée au moyen de la première impédance caractéristique de la ligne de transmission radiale (19) et d'un rayon intérieur et extérieur de la ligne de transmission coaxiale (21) et d'une impédance caractéristique d'ondes.

15. Procédé selon la revendication 13 ou 14, **caractérisé en ce que** dans la zone de transition (Ü) du premier étage (17) des parois s'étendant perpendiculairement à l'axe principal de propagation d'ondes (HA) de la première ligne de transmission radiale (19) se prolongent de manière régulière, selon des allures en forme de courbe, à symétrie de révolution par rapport à l'axe principal de propagation d'ondes (HA), par des parois s'étendant longitudinalement par rapport à ce dernier de la ligne de transmission coaxiale (21).

16. Procédé selon la revendication 14, **caractérisé en ce que** dans la zone de transition (Ü) du premier étage (17) une première étendue de matière spatiale est créée, laquelle présente des sections transversales de forme circulaire et perpendiculaires à l'axe principal de propagation d'ondes (HA), dont les rayons le long et dans le sens de la direction de l'axe principal de propagation d'ondes (HA), depuis le rayon extérieur du conducteur extérieur (27) vers le rayon extérieur du conducteur intérieur (25) de la ligne de transmission coaxiale (21), se réduisent et diminuent de façon régulière.

17. Procédé selon la revendication 16, **caractérisé en ce que** les rayons des sections transversales de la première étendue de matière spatiale, depuis le côté de la ligne de transmission radiale (19) vers le côté de la ligne de transmission coaxiale (21), se réduisent et diminuent de façon exponentielle.

18. Procédé selon la revendication 15, 16 ou 17, **caractérisé en ce que** dans la zone de transition (Ü) du premier étage (17) une deuxième étendue de matière spatiale est créée, laquelle présente des sections transversales de forme circulaire et perpendiculaires à l'axe principal de propagation d'ondes (HA), dont les rayons extérieurs sont constants et dont les rayons intérieurs le long et dans le sens de la direction de l'axe principal de propagation d'ondes (HA), depuis le rayon extérieur vers le rayon intérieur du conducteur extérieur (27) de la ligne de transmission coaxiale (27), se réduisent et diminuent de façon régulière.

19. Procédé selon la revendication 18, **caractérisé en ce que** les rayons intérieurs des sections transversales de la deuxième étendue de matière spatiale, depuis le côté de la ligne de transmission radiale (19) vers le côté de la ligne de transmission coaxiale (21), se réduisent et diminuent de façon exponentielle.

20. Procédé selon la revendication 18 ou 19, **caractérisé en ce que** les allures des rayons des sections transversales de la première étendue de matière spatiale et des rayons intérieurs des sections transversales de la deuxième étendue de matière spatiale, depuis le côté de la ligne de transmission radiale (19) vers le côté de la ligne de transmission coaxiale (21), sont parallèles les unes aux autres.

21. Procédé selon l'une des revendications précédentes 16 à 20, **caractérisé en ce que** la première étendue de matière spatiale se présente sous la forme d'un élément intermédiaire (23) séparé.

22. Procédé selon la revendication 21, **caractérisé en ce que** ledit élément intermédiaire (23) présente le long et dans le sens de la direction de l'axe principal de propagation d'ondes (HA) une allure des faces extérieures en forme d'entonnoir se rétrécissant.

23. Procédé selon l'une des revendications précédentes 18 à 22, **caractérisé en ce que** la première et la deuxième étendue de matière spatiale sont formées de la même matière, en particulier de cuivre, d'acier ou d'aluminium.

24. Procédé selon l'une des revendications précédentes 13 à 23, **caractérisé en ce que** concernant leur couplage électrotechnique, l'ensemble des n étages ont la même structure modulaire.

FIG 1

FIG 2

FIG 3

FIG 4

t [ns]

## FIG 5

## FIG 6

FIG 7

FIG 8

FIG 9

R53.3

R45

23

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Pulsed Power Systems Principles and Applications. Hansjochim Bluhm. Springer Verlag, 2006, 192-201
- **KOHNO, S. et al.** High-current pulsed power generator ASO-X using inductive voltage adder and inductive energy storage system. *Japanese journal of applied physics, Japanese society of applied physics,* Mai 2000, vol. 39 (5A), 2829-2833
- **THOMAS, K. J. et al.** LINX and future IVA machines. *Proc. IEE Pulsed Power,* April 1999, vol. 99, 2, , 1-2, 4